# NEUE EUROPÄISCHE PATENTSCHRIFT

(11) **EP 0 686 662 B2**
(45) Veröffentlichungstag und Bekanntmachung des Hinweises auf die Entscheidung über den Einspruch: **24.05.2006**
(45) Hinweis auf die Patenterteilung: 27.11.2002
(21) Anmeldenummer: 95106073.0
(22) Anmeldetag: 24.04.1995
(51) Int. Cl.: C08K 5/092, C08L 65/00, C08G 61/12

(54) **Leitfähige Beschichtungen**
Conductive coatings
Revêtements conducteurs

(30) Priorität: 06.05.1994 DE 4416117; 03.03.1995 DE 19507413
(43) Veröffentlichungstag der Anmeldung: 13.12.1995
(60) Teilanmeldung: 01121781.7
(73) Patentinhaber: BAYER AG, 51368 Leverkusen (DE)
(72) Erfinder: Jonas, Friedrich, Dr., D-52066 Aachen (DE); Karbach, Alexander, Dr., D-47800 Krefeld (DE); Muys, Bavo, B-2640 Mortsel (BE); van Thillo, Etienne, B-2910 Essen (BE); Wehrmann, Rolf, Dr., D-47800 Krefeld (DE); Elschner, Andreas, Dr., D-45479 Mülheim (DE); Dujardin, Ralf, Dr., D-47877 Willich (DE)

(56) Entgegenhaltungen:
- EP-A- 0 440 957
- EP-A- 0 564 911
- PATENT ABSTRACTS OF JAPAN vol. 013, no. 182 (C-591), 27.April 1989 & JP 01 011128 A (AGENCY OF IND SCIENCE & TECHNOL), 13.Januar 1989,

## Beschreibung

Auf dem Elektronikgebiet werden z. B. für LCD-Displays elektrisch leitfähige, transparente Elektroden benötigt. Bisher werden für diese Anwendungen meist mit Metalloxiden bedampfte Gläser oder Kunststofffolien verwendet. Besonders gute Eigenschaften haben ITO = Indium Zinnoxid bedampfte bzw. besputterte Materialien. Der Oberflächenwiderstand der ITO-Schichten liegt in der Größenordnung von <500 Ω/□.

Die Herstellung solcher Schichten durch Aufsputtern im Vakuum ist sehr aufwendig. Es besteht daher ein Bedarf an einem Material, das die Herstellung transparenter, gut leitfähiger Beschichtungen mit einfachen Auftragstechniken ermöglicht.

Die Herstellung leitfähiger Beschichtungen auf Basis organischer leitfähiger Materialien ist prinzipiell bekannt. So sind z. B. Beschichtungen aus Polypyrrol (EP-A 302 304) oder Polythiophenderivaten (EP-A 440 957) beschrieben. Diese Beschichtungen können mit einfachen Beschichtungsverfahren hergestellt werden, sind aber für viele Einsatzgebiete nicht leitfähig bzw. transparent genug.

Gegenstand der Erfindung sind leitfähige Beschichtungen aus Mischungen enthaltend
A) eine wässrige Lösung oder Dispersion eines Polythiophenes in kationischer Form und Polyanionen, wobei das Polythiophen wiederkehrende Struktureinheiten der Formel (I), 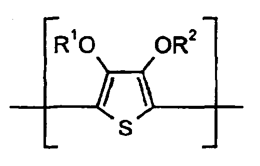 enthält, in der
   - R₁ und R₂: unabhängig voneinander für Wasserstoff oder eine C₁₋₄-Alkylgruppe stehen oder zusammen einen gegebenenfalls substituierten C₁₋₄-Alkylenrest, vorzugsweise einen gegebenenfalls durch Alkylgruppen substituierten Methylen-, einen gegebenenfalls durch C₁₋₁₂-Alkyl- oder Phenylgruppen substituierten Ethylen-1,2-Rest oder einen Cyclohexylen-1,2-Rest bilden, und
B) Di- oder Polyhydroxy- und/oder Carbonsäuregruppen enthaltende organische Verbindungen - ausgenommen Polyvinylalkohol - in einer Menge von 1 bis 100 000 Gew.-%, bezogen auf die Summe aus Polythiophenkationen und Polyanionen,
dadurch gekennzeichnet, dass sie zur Erhöhung der Leitfähigkeit getempert worden sind, und dass sie einen Oberflächenwiderstand von 0,1 bis 2000 Ω/□ aufweisen.

Geeignete Di- oder Polyhydroxy- und/oder Carbonsäuregruppen enthaltende organische Verbindungen entsprechen der Formel (II) 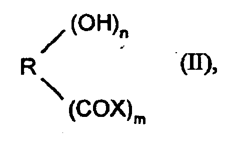 in der
n und m unabhängig voneinander eine ganze Zahl bis 20, bevorzugt von 2 bis 8 und
- R: einen linearen, verzweigten oder cyclischen Alkylenrest mit 2 bis 20 C-Atomen oder einen gegebenenfalls substituierten Arylenrest mit 6 bis 14 C-Atomen oder einen heterocyclischen Rest mit 4 bis 10 C-Atomen oder einen Zuckerrest bzw. Zuckeralkoholrest und
- X: -OH bedeutet.

Bevorzugte Reste R leiten sich vom Furangerüst bzw. Pyrangerüst ab.

Besonders bevorzugte organische Verbindungen der Formel (II) sind:

Zucker und Zuckerderivate wie Saccharose, Glucose, Fructose, Lactose Zuckeralkohole wie Sorbit, Mannit
Furanderivate wie 2-Furancarbonsäure, 3-Furancarbonsäure
Alkohole wie Ethylenglykol, Glycerin, Di- bzw. Triethylenglykol.

Als Lösungsmittel für die erfindungsgemäße Polythiophen-Dispersionen kommen neben Wasser auch andere protische Lösungsmittel in Betracht, z.B. niedere Alkohole wie Methanol, Ethanol und Isopropanol sowie Mischungen von Wasser mit niederen Alkoholen und andere mit Wasser mischbaren organischen Lösungsmittel wie Aceton.

Die mittleren Teilchendurchmesser der Dispersionspartikel können bis 10 µm erreichen, bevorzugt bis 3 µm und ganz besonders bevorzugt bis 1 µm.

Die Polythiophene der wiederkehrenden Struktureinheit der Formel (I) sind bekannt (vgl. EP-A 440 958 und 339 340). Die Herstellung der erfindungsgemäßen Dispersionen bzw. Lösungen ist in EP-A 440 957 und DE-OS 4 211 459 beschrieben.

Die Polythiophene werden in der Dispersion bzw. Lösung in kationischer Form, wie sie z.B. durch Behandlung der neutralen Thiophene mit Oxidationsmitteln erhalten werden, eingesetzt. Übliche Oxidationsmittel wie Kaliumperoxodisulfat werden für die Oxidation verwendet. Durch die Oxidation erhalten die.Polythiophene positive Ladungen, die in den Formeln nicht dargestefft sind, da ihre Zahl und ihre Position nicht einwandfrei feststellbar sind.

Die Zahl der wiederkehrenden Struktureinheiten der Formel (I) ist im allgemeinen > 5.

Die erfindungsgemäßen Polythiophen-Dispersionen bzw. Lösungen enthalten, bezogen auf die Summe aus Polythiophenkationen und Polyanionen, d. h. bezogen auf den gesamten Feststoffgehalt der Lösung, 1 bis 100.000 Gew.-%, bevorzugt 10 bis 1.000 Gew.-%, der Hydroxy- bzw. Carbonsäuregruppen enthaltenden Verbindungen der Formel (II). Verbindungen der Formel (II), die in Wasser löslich sind, werden bevorzugt verwendet.

Den erfindungsgemäßen Beschichtungslösungen können zusätzlich organische, polymere Bindemittel und/oder organische, niedermolekulare Vernetzungsmittel zugegeben werden. Entsprechende Bindemittel sind z. B. in der EP-A 564 911 beschrieben.

Besonders zur Herstellung haftfester Schichten auf Glas können den erfindungsgemäßen Beschichtungslösungen Epoxisilane, wie in der EP-A 564 911 beschrieben, zugesetzt werden.

Die erfindungsgemäßen Beschichtungen können nach bekannten Verfahren, z.B. durch Aufsprühen, Aufrakein, Tauchen, Aufbringen mit Walzenantragssystemen, Druckverfahren wie Tiefdruck, Siebdruck, Vorhanggießen hergestellt und bei Raumtemperatur oder bei Temperaturen bis 300°C, bevorzugt bis 200°C getrocknet werden.

An die Trocknung bei Temperaturen unter 100°C schließt sich eine separate Temperung und bei Trocknungstemperaturen oberhalb 100°C eine kombinierte Temperung der erfindungsgemäßen Schichten zur Erhöhung der elektrischen Leitfähigkeit an. Diese Temperung wird bei Temperaturen von 100°C bis 400°C, bevorzugt bis 250°C durchgeführt. Die Dauer der Temperung liegt zwischen 0,5 bis 3600 Sekunden, bevorzugt 1 bis 90 Sekunden.

Die Dicke der erfindungsgemäßen Beschichtungen ist je nach Einsatzzweck und Anforderungen an Transparenz und Leitfähigkeit 0,025 bis 250 µm, bevorzugt 0,05 bis 10 um; der Oberflächenwiderstand der erfindungsgemäßen Beschichtungen beträgt 0,1 bis 2000 Ω/□, bevorzugt 1 bis 300 Ω/□.

Die erfindungsgemäßen Beschichtungen werden auf Gebieten, die gute elektrische Leitfähigkeiten erfordern, eingesetzt, z.B. als Elektrode in Elektrolumineszenzanzeigen, in LCD-Anzeigen, in Feststoffelektrolytkondensatoren, zur Abscheidung von Metallen wie Kupfer Nickel, z. B. bei der Leiterplattenfertigung, in Solarzellen, in elektrochromen Anzeigen oder zur Abschirmung elektromagnetischer Strahlung bzw. zur Ableitung elektrischer Ladungen z. B. auf Bildröhren oder als Antikorrosionsbeschichtung auf Metallen, zur Herstellung von Touch Screens. Weitere Einsatzgebiete sind bilderzeugende Systeme, z.B. Silberhalogenidfotografie, trockene Bildsysteme, Elektrofotografie.

Die leitfähigen Schichten können gegebenenfalls mit weiteren Schichten, z.B. UV härtenden oderorganischen bzw. anorganischen Kratzfestbeschichtungen beschichtet werden.

Die erfindungsgemäßen Schichten können auf organische und auf anorganische Trägermaterialien aufgebracht werden. Geeignete anorganische Trägermaterialien sind z.B. Glas, Oxide bzw. oxidische oder nicht oxidische Keramiken wie Aluminiumoxid, Siliciumnitrid. Geeignete organische Trägermaterialien sind z.B. Folien oder andere Formkörper aus reinen organischen Polymeren, Copolymeren oder Mischungen von z.B. Polycarbonat, Polystyrol, Polyacrylaten, Polyestern wie Polyethylenterephthalat, Polybutylenterephthalat, Polyethylennaphthalat, Polyamiden, Polyimiden, gegebenenfalls glasfaserverstärkten Epoxidharzen, Cellulosederivaten wie Cellulosetriacetat, Polyolefinen wie Polyethylen, Polypropylen.

Gegenstand der Erfindung sind weiterhin elektrolumineszierende Anordnungen, die als transparente und leitfähige Schicht bzw. Elektrode die erfindungsgemäßen Polythiophen-Dispersionen aufweisen.

Die erfindungsgemäßen elektrolumineszierenden Anordnungen bestehen aus einer oberen und einer unteren Elektrode, zwischen die eine elektrolumineszierende Schicht und gegebenenfalls weitere Hilfsschichten, z.B. ladungsinjizierende Schichten, eingefügt werden, und sind dadurch gekennzeichnet, dass sie als Elektrode eine leitfähige Schicht aus den erfindungsgemäßen Polythiophen- Mischungen aufweisen.

Die elektrolumineszierende Anordnung kann eine oder mehrere Elektroden enthalten, deren leitfähige Schicht die oben genannten Polythiophen-Dispersionen aufweisen. Die leitfähige Schicht ist vorzugsweise transparent.

Beim Aufbau der elektrolumineszierenden Anordnungen kann die leitfähige Schicht an unterschiedlichen Stellen integriert werden. So kann die leitfähige Schicht als transparente und leitfähige Elektrode zwischen einem transparenten Substrat und einer elektrolumineszierenden Schicht aufgebracht sein.

Dazu wird bei den erfindungsgemäßen Systemen die erfindungsgemäßen Mischungen auf einem geeigneten Substrat als Film verteilt.

Als Substrat sind transparente Träger wie Glas oder Kunststoff-Folien (z.B. Polyester, wie Polyethylenterephthalat oder Polyethylennaphthalat, Polycarbonat, Polyacrylat, Polysulfon, Polyimid-Folie) geeignet.

Die erfindungsgemäße Polythiophen-Mischung wird durch Techniken wie Spincoaten, Casting, Rakeln, Drukken, Vorhanggießen etc. auf dem Substrat gleichmäßig verteilt.

Nach Trocknen des Films kann das so beschichtete Substrat einer Temperatur von 150-250°C für mindestens 1 sec, in der Regel 30 sec ausgesetzt werden. Dieser Temperschritt führt zu einer Erhöhung der Schichtleitfähigkeit.

Die Dicke der transparenten leitfähigen Elektrode beträgt 5 nm bis mehrere µm, vorzugsweise 10 nm bis 1500 nm.

Auf diese leitfähige transparente Elektrode wird eine elektrolumineszierende Schicht als dünner Film aufgebracht. Die z.B. in EP-A 443 861 beschriebenen Substanzen können als elektrolumineszierende Substanzen verwendet werden.

Nach dem Trocknen der El-Schicht wird diese mit einer Gegenelektrode ausgerüstet. Diese besteht aus einer leitfähigen Substanz, die transparent sein kann. Vorzugsweise eignen sich Metalle wie Al, Au, Ag, etc. oder deren Legierungen und Oxide, die durch Techniken wie Aufdampfen, Aufputtern, Platinierung aufzubringen sind.

Die erfindungsgemäße Anordnung wird durch zwei elektrische Zuführungen (z.B.Metalldrähte) mit den beiden Elektroden in Kontakt gebracht.

Die Anordnungen emittieren beim Anlegen einer Gleichspannung im Bereich von 2 bis 100 Volt Licht der Wellenlänge von 400 bis 700 nm. Sie zeigen im Bereich von 400 bis 700 nm Photolumineszenz.

Die elektrolumineszierende Schicht kann eine oder mehrere elektrooptisch aktive Substanzen enthalten. Sie enthält gegebenenfalls weiterhin übliche Zusätze wie inerte Binder, ladungsträgertransportierende Substanzen. Ladungsträgertransportierende Substanzen erhöhen die Elektrolumineszintensität und reduzieren die Einsatzspannungen.

Als inerte Binder werden vorzugsweise löslich transparente Polymere wie z.B. Polycarbonate, Polystyrol und Copolymere des Polystyrols wie SAN, Polysulfone, Polyacrylate, Polyvinylcarbazol, Vinylacetat- und Vinylalkoholpolymere und -copolymere usw. eingesetzt.

Zwischen den elektrolumineszierenden Systemen und den Elektroden können zusätzlich eine oder mehrere Zwischenschichten angeordnet sein. Diese Zwischenschichten - ladungsträgertransportierende Substanzen-sind bekannt (z.B. aus Appl. Phys. Lett. 57 (1990) 531) und werden dort als HTL (hole transport layer) und als ETL (elektron transport layer) bezeichnet.

Die leitfähigen Schichten können ebenfalls als transparente und leitfähige Elektrode in Form einer Deckschicht auf einer elektrolumineszierenden Schicht aufgebracht sein.

In Gegensatz zu der vorher beschriebenen Anordnung, bei der sich die erfindungsgemäße Mischung zwischen einer elektrolumineszierenden Schicht und einem transparenten Träger befindet, kann die erfindungsgemäße Substanz auch als Deckelelektrode eingesetzt werden.

Bei dieser Anwendung befindet sich die elektrolumineszierende Substanz auf einem leitfähigen oder leitfähigbeschichtetem Träger. Dies können z.B. Metallplatten oder Metallbedampfungen sein. Die erfindungsgemäße Substanz wird analog der oben beschriebenen Art auf die elektroluminesizierende Schicht aufgebracht.

Der Vorteil dieser Anordnung ist, dass auf diese Weise auch elektrolumineszierende Schichten, die bei der Herstellung einer großen Wärmebelastung ausgesetzt sind, mit einer einfach applizierbaren, transparenten und leitfähigen Elektrode versehen werden können.

Beispiel: Leuchtplatten aus Leuchtstoffemails auf Basis von ZnS.

Die erfindungsgemäßen Mischungen können weiterhin als ladungstransportierende Zwischenschicht in polymeren Leuchtdioden eingesetzt werden. Durch diese Zwischenschicht wird die Effizienz der Anordnungen erhöht.

Die erfindungsgemäße Mischung wird in oben beschriebener Art als Zwischenschicht aufgebracht. Die Zwischenschicht kann sich befinden:
- zwischen der transparenten leitfähigen Elektrode und der elektrolumineszierenden Polymerschicht,
- zwischen der elektrolumineszierenden Polymerschicht und der Deckelektrode.

Die Dicke der Zwischenschicht beträgt etwa 3- 200 nm, in der Regel 10 nm -100 nm, besonders bevorzugt ca. 10 nm.

### Beispiele:

### A) Herstellung der 3,4-Polyethylendioxythiophenlösung

20 g freie Polystyrolsulfonsäure (Mn ca. 40000) 13,0 g Kaliumperoxodisulfat und 50 mg Eisen(III)-sulfat werden unter Rühren in 2000 ml Wasser vorgelegt. Unter Rühren werden 5,6 g 3,4- Ethylendioxythiophen zugegeben. Die Lösung wird 24 h bei Raumtemperatur gerührt. Anschließend werden 100 g Anionenaustauscher (Handelsprodukt Bayer AG Lewatit MP 62) und 100 g Kationenaustauscher (Handelsprodukt Bayer AG Lewatit S 100), beide wasserfeucht, zugegeben und 8 Stunden gerührt.

Die Ionenaustauscher werden durch Filtration entfernt. Es wird eine Lösung mit einem Feststoffgehalt von ca: 1,2 Gew.% erhalten, die gebrauchsfertig ist.

### Beispiel 1:

Es werden jeweils 10,0 der Lösung nach Beispiel A mit 1 0 g Isopropanol und den in der Tabelle angegebenen Mengen Sorbit und 3-Glycidoxypropyltrimethoxysilan (Handelsprodukt A 187 Union Carbide) gemischt. Die Mischung wird auf Glasplatten aufgetragen und an der Luft getrocknet (ca. 400 mg /m² trocken).

An den getrockneten Schichten wird der Oberflächenwiderstand bestimmt. Anschließend werden die beschichteten Glasplatten für 90 Sekunden auf eine 200°C heiße Heizplatte gelegt und nach dem Abkühlen der Oberflächenwiderstand erneut bestimmt.

**Tabelle:**

| A 187 | Sorbit | Oberflächenwiderstand [Ω/□] | |
|---|---|---|---|
| [g] | [g] | vor | nach Temperung |
| 0,2 | --- | 3500 | 3500 |
| 0,1 | 0,2 | 3400 | 120 |
| 0,2 | 0,2 | 3500 | 180 |
| 0,4 | 0,2 | 3300 | 300 |
| 0,1 | 0,6 | 4000 | 90. |
| 0,2 | 0,6 | 3800 | 105 |
| 0,4 | 0,6 | 3950 | 125 |

Aus der Tabelle wird deutlich, dass das erfindungsgemäße Verfahren zu deutlich besser leitfähigen Beschichtungen führt, als die 3,4-Polyethylendioxythiophenlösung ohne Zusätze und Temperung.

### Beispiel 2:

### Elektrolumineszierende Anordnung

### B) Herstellung der Beschichtungslösung

In 50 g der Lösung A werden unter Rühren 3,0 g Sorbit gelöst. Anschließend werden unter Rühren 50 g Isopropanol zugetropft und 0,5 g Glycidoxypropyltrimethoxysilan (A 187 Handelsprodukt der Union Carbide) zugegeben.

### C) Herstellung der 3,4-Polyethylendioxythlophenelektrode

Die Lösung B wird auf einen Glasobjektträger (20 x 30 mm²) gegeben. Das Substrat wird anschließend 10 sec lang bei 500 U/min mit einer Lackschleuder rotiert. Das mit dem Film beschichtete Substrat wird 60 sec lang auf eine 180°C heiße Heizplatte gelegt. Der Oberflächenwiderstand reduziert sich dabei auf 80 Ω/□ Die Schichtdicke des Films beträgt 1,3 µm. Der Film ist im sichtbaren Spektralbereich transparent.

Auf diese Schicht wird anschließend das elektrolumineszierende Polymer aufgebracht.

### D) Aufbringen einer elektrolumineszierenden Schicht auf die 3,4-Polyethylendioxythiophenelektrode

Als elektrolumineszierendes Material wird das aus der Literatur bekannte MEH-PPV (Methoxy-Ethylenhexyloxy-Phenylenvinylen) eingesetzt. Eine 0,75 %-ige Lösung des Polymers in Chloroform wird 10 sec lang bei 2 000 U/min mit einer Lackschleuder auf der mit dem Polythiphen beschichteten Substrat aus Beispiel 2 C) verteilt. Der 130 nm dicke Polymerfilm wird anschließend mit Al-Punktkontakten bedampft.

### E) Betrieb der flexiblen Polymer-Leuchtdiode

Wird der Pluskontakt einer Spannungsquelle mit der PEDT-Schicht verbunden und der Minuskontakt mit dem Al, so fließt durch das elektrolumineszierende Polymer ein Strom. Gleichzeitig tritt Elektrolumineszenz auf. Die Leuchtintensität ist proportional zum Diodenstrom und nimmt mit steigender Spannung zu.

## Patentansprüche

1. Leitfähige Beschichtungen aus Mischungen enthaltend
A) eine wässrige Lösung oder Dispersion eines Polythiophenes in kationischer Form und Polyanionen, wobei das Polythiophen wiederkehrende Struktureinheiten der Formel (I) 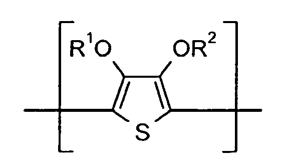 enthält, in der
R₁ und R₂ unabhängig voneinander für Wasserstoff oder eine C₁₋₄-Alkylgruppe stehen oder zusammen einen gegebenenfalls substituierten C₁₋₄-Alkylenrest, vorzugsweise einen gegebenenfalls durch Alkylgruppen substituierten Methylen-, einen gegebenenfalls, durch C₁₋₁₂-Alkyl- oder Phenylgruppen substituierten Ethylen-1,2-Rest oder einen Cyclohexylen-1,2-Rest bilden, und
B) Di- oder Polyhydroxy- und/oder Carbonsäuregruppen enthaltende organische Verbindungen - ausgenommen Polyvinylalkohol - in einer Menge von 1 bis 100 000 Gew.-%, bezogen auf die Summe aus Polythiophenkationen und Polyanionen,
**dadurch gekennzeichnet, dass** sie zur Erhöhung der Leitfähigkeit getempert worden sind und dass sie einen Oberflächenwiderstand von 0,1 bis 2000 Ω/**□** aufweisen.

2. Leitfähige Beschichtungen nach Anspruch 1, **dadurch gekennzeichnet, dass** es sich bei den organischen Verbindungen B) um Zucker, Zuckeralkohole, Furanderivate oder Di- oder Polyhydroxygruppen enthaltende Alkohole handelt.

3. Leitfähige Beschichtungen nach Anspruch 2, **dadurch gekennzeichnet, dass** es sich bei den organischen Verbindungen B) um Saccharose, Glucose, Fructose, Lactose, Sorbit, Mannit, 2-Furancarbonsäure, 3-Furancarbonsäure, Ethylenglykol, Glycerin, Di- oder Triethylenglykol handelt.

4. Leitfähige Beschichtungen nach Anspruch 1, **dadurch gekennzeichnet, dass** es sich bei den Polyanionen um Polystyrolsulfonsäure handelt.

5. Verwendung der leitfähigen Beschichtung nach Anspruch 1 als ladungstransportierende Zwischenschicht in polymeren Leuchtdioden.

6. Leitfähige Beschichtung nach Anspruch 1, **dadurch gekennzeichnet, dass** der Oberflächenwiderstand < 300 Ω/□ ist.

7. Elektrolumineszierende Anordnung, bestehend aus einer oberen und einer unteren Elektrode, zwischen die eine elektrolumineszierende Schicht und gegebenenfalls weitere Hilfsschichten eingefügt werden, **dadurch gekennzeichnet, dass** als Elektrode eine leitfähige Schicht gemäß Anspruch 1 verwendet wird.

## Claims

1. Conductive coatings from mixtures containing
A) an aqueous solution or dispersion of a polythiophene in cationic form and polyanions, the polythiophene containing recurring structural units of the formula (I) 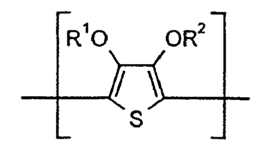 where
R₁ and R₂ independently of one another represent hydrogen or a C₁₋₄-alkyl group or together form an optionally substituted C₁₋₄-alkylene radical, preferably an optionally alkyl-substituted methylene radical, an optionally C₁₋₁₂-alkyl- or phenyl-substituted 1,2-ethylene radical or a 1,2-cyclohexylene radical, and
B) 1 to 100 000% by weight, based on the sum of polythiophene cations and polyanions, of organic compounds other than polyvinyl alcohol that contain di- or polyhydroxy and/or carboxylic acid groups,
**characterized in that** they have been annealed to increase the conductivity and **in that** they have a surface resistance of from 0.1 to 2000 Ω/□.

2. Conductive coatings according to Claim 1, **characterized in that** the organic compounds B) are sugar, sugar alcohols, furan derivatives or alcohols containing di- or polyhydroxy groups.

3. Conductive coatings according to Claim 2, **characterized in that** the organic compounds B) are sucrose, glucose, fructose, lactose, sorbitol, mannitol, 2-furancarboxylic acid, 3-furancarboxylic acid, ethylene glycol, glycerol, diethylene glycol or triethylene glycol.

4. Conductive coatings according to Claim 1, **characterized in that** the polyanions are polystyrenesulphonic acid.

5. Use of the conductive coating according to Claim 1 as a charge-transporting interlayer in polymeric luminescent diodes.

6. Conductive coating according to Claim 1, **characterized in that** the surface resistance is < 300 Ω/□.

7. Electroluminescent system consisting of an upper and a lower electrode, between which an electroluminescent layer and optionally other auxiliary layers are inserted, **characterized in that** the electrode used is a conductive layer according to Claim 1.

## Revendications

1. Revêtements conducteurs constitués de mélanges contenant :
A) une solution ou dispersion aqueuse d'un polythiophène sous forme cationique et de polyanions, où le polythiophène contient les unités structurales récurrentes de la formule (I) : 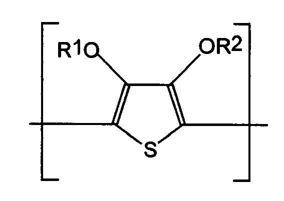 dans laquelle :
R¹ et R² représentent indépendamment l'un de l'autre, l'atome d'hydrogène ou un radical alcoyle en C₁₋₄ ou forment ensemble, un reste alcoylène en C₁₋₄ le cas échéant substitué, de préférence un reste méthylène le cas échéant substitué par un radical alcoyle, un reste éthylène-1,2 le cas échéant substitué par un radical alcoyle en C₁₋₁₂ ou phényle, ou un reste cyclohexylène-1,2, et
B) des composés organiques contenant des radicaux di- ou polyhydroxyle et/ou acide carboxylique, à l'exception du polyvinylalcool, en une quantité allant de 1 à 100 000% en poids, sur base de la somme des cations polythiophène et des polyanions,
**caractérisé en ce qu'**ils sont recuits pour augmenter la conductibilité et qu'ils présentent une résistance surfacique allant de 0,1 à 2000 Ω/□.

2. Revêtements conducteurs suivant la revendication 1, **caractérisés en ce que** les composés organiques B) consistent en des sucres, alcools de sucre, dérivés du furanne ou alcools contenant des radicaux di- ou polyhydroxyle.

3. Revêtements conducteurs suivant la revendication 2, **caractérisés en ce que** les composés organiques B) consistent en le saccharose, le glucose, le fructose, le lactose, le sorbitol, le mannitol, l'acide 2-furannecarboxylique, l'acide 3-furannecarboxylique, l'éthylèneglycol, la glycérine, le di- ou le triéthylèneglycol.

4. Revêtements conducteurs suivant la revendication 1, **caractérisés en ce que** les polyanions consistent en des poly(acides styrènesulfoniques).

5. Utilisation du revêtement conducteur suivant la revendication 1, comme couche intermédiaire transportant des charges dans des diodes lumineuses polymères.

6. Revêtement conducteur suivant la revendication 1, **caractérisé en ce que** la résistance surfacique est < 300 Ω/□.

7. Structure électroluminescente, consistant en une électrode supérieure et une électrode inférieure, entre lesquelles une couche électroluminescente et le cas échéant, d'autres couches auxiliaires sont incorporées, **caractérisée en ce que** l'on utilise comme électrode, une couche conductrice suivant la revendication 1.
